Europäisches Patentamt

European Patent Office

Office européen des brevets

(19)

(11) Veröffentlichungsnummer: **0 018 521**
**A1**

(12) # EUROPÄISCHE PATENTANMELDUNG

(21) Anmeldenummer: 80101933.2

(22) Anmeldetag: 10.04.80

(51) Int. Cl.³: **H 02 J 9/06**
**H 02 J 3/32, G 01 R 31/36**

(30) Priorität: 14.04.79 DE 2915222

(43) Veröffentlichungstag der Anmeldung:
12.11.80 Patentblatt 80 23

(84) Benannte Vertragsstaaten:
AT BE CH GB LI NL

(71) Anmelder: **Licentia Patent-Verwaltungs-GmbH**
**Theodor-Stern-Kai 1**
**D-6000 Frankfurt/Main 70(DE)**

(72) Erfinder: **Clewing, Michael, Dr.-Ing.**
**Talstrasse 1**
**D-4788 Warstein 2 Belecke(DE)**

(74) Vertreter: **Lertes, Kurt, Dr.**
**Licentia Patent-Verwaltungs-GmbH Theodor-Stern-Kai**
**1**
**D-6000 Frankfurt 70(DE)**

(54) Einrichtung zur kontinuierlichen Wechselstromversorgung von Verbrauchern.

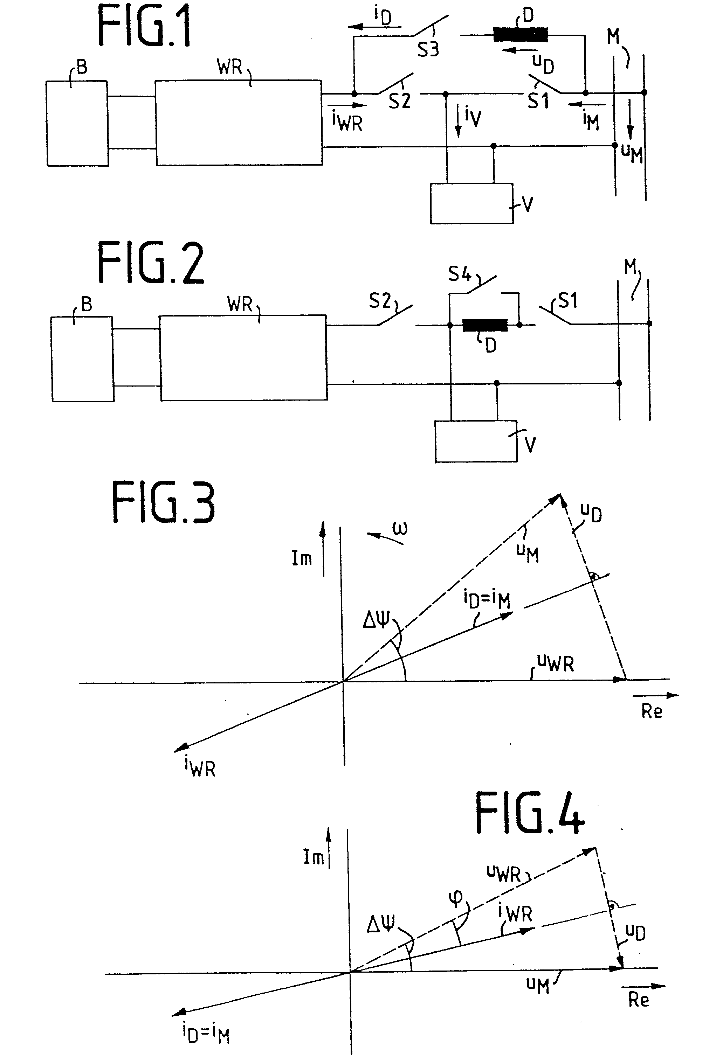

(57) Einrichtung für kontinuierliche Wechselstromversorgung, wahlweise ein Wechselstromnetz oder einen statischen Umformer (Wechselrichter) enthaltend, ein erster Schalter ist zwischen dem Wechselstromnetz und Verbrauchern, ein zweiter Schalter zwischen den Verbrauchern und dem statischen Umformer angeordnet, bei welcher Einrichtung zwischen dem statischen Umformer und dem Wechselstromnetz ferner eine Impedanz und ein dritter Schalter angeordnet sind und dem statischen Umformer eine zusätzliche Steuerungseinrichtung zugeordnet ist, mit der jeweils eine Phasenabweichung der Wechselspannung des Umformers von der Spannung des Wechselstromnetzes einstellbar ist, wodurch diese Wechselspannungen für den Parallelbetrieb des Wechselrichters und des Wechselstromnetzes synchronisiert werden, und mit der bei Normalstromversorgung der Verbraucher ein aus dem Wechselstromnetz über den als Gleichrichter wirkenden Umformer fließender Strom für die Ladung einer Batterie oder ein hieraus über den als Wechselrichter wirkenden Umformer in das Wechselstromnetz fließender Strom für eine Entladung der Batterie einstell- oder regelbar ist (Fig. 1 und 3).

FIG.3

FIG.4

EP 0 018 521 A1

Licentia Patent-Verwaltungs-G.m.b.H.
6 Frankfurt/Main 70, Theodor-Stern-Kai 1

Einrichtung zur kontinuierlichen Wechselstromversorgung von Verbrauchern

Die Erfindung bezieht sich auf eine Einrichtung für die
kontinuierliche Wechselstromversorgung von Verbrauchern
mit Normalstromversorgung aus einem Wechselstromnetz oder
über einen als Wechselrichter gesteuerten statischen Umformer, bei welcher Einrichtung ein erster Schalter zwischen Wechselstromnetz und den Verbrauchern (einerseits)
sowie ein zweiter Schalter zwischen den Verbrauchern und
dem Wechselrichter (andererseits) angeordnet sind.

Eine derartige Einrichtung ist bekannt durch DE-AS
18 03 221 als Anordnung zur unterbrechungsfreien Stromversorgung eines Wechselstromverbrauchers. Dabei ist
ein mit dem erwähnten ersten Schalter funktionell vergleichbares Schaltelement als Schaltkontakt eines spannungsempfindlichen Relais ausgebildet, der geschlossen
ist, wenn die Spannung des verwendeten Wechselstromnetzes genügend groß ist. Dieses ist bei geschlossenem
Schaltkontakt an den Ausgangstransformator eines als
Wechselrichter gesteuerten reversiblen Umformers über
eine Drossel angeschlossen und somit an den Wechselstromausgang des Umformers angekoppelt, wobei zwischen der Netzspannung und der Wechselrichterspannung ein Phasenunterschied besteht. Dieser wird mittels einer dem statischen Umformer zugeordneten Steuereinheit erfaßt, die in Abhängigkeit von der Netzspannung durch das spannungsempfindliche Relais ein- bzw. ausgeschaltet wird. Der Phasenunterschied ist steuerbar und ergibt eine Steuerung des Strom- und Ladungsflusses des statischen Umformers entweder von der Batterie in die Verbraucher oder vom Wechselstromnetz in die Batterie. Die erwähnte Drossel ist Bestandteil eines gesättigten Resonanzschwingkreises, der dem Ausgangstransformator des Umformers zugeordnet ist, so daß der Ausgangstransformator wie ein Konstantspannungstransformator wirkt. Wenn das Wechselstromnetz ausfällt und der statische Umformer als Wechselrichter den vollen Strom für die Verbraucher übernimmt, dann begrenzt die Drossel diesen Strom.

Die betreffende Einrichtung kann nur mit einem spezifisch ausgebildeten Wechselrichter arbeiten, und sie ist, da der Ausgangstransformator als Spannungskonstanthalter ausgeführt ist, lediglich zur Abgabe kleiner Leistungen geeignet.

Durch die DE-AS 24 52 921 ist ebenfalls eine Einrichtung der eingangs angegebenen Art bekannt, die eine Schaltungsanordnung zur unterbrechungsfreien Stromversorgung von Wechselstromverbrauchern darstellt. Diese enthält einen reversiblen statischen Umformer, gesteuert als Wechselrichter für die Ersatzstromversorgung von Verbrauchern mit Wechselstrom, wenn die Normalstromversorgung aus einem Wechselstromnetz ausgefallen ist. Bei Normalstromversorgung der Verbraucher aus dem Wechselstromnetz ist der erwähnte Umformer als Gleichrichter gesteuert zur Auf- oder Nachladung einer Batterie, die als Energiequelle für die Ersatzstromversorgung dient. Der Wechselstromausgang (s. Fig. 3) des reversiblen statischen Umformers ist direkt an den Verbraucher angeschlossen und ist bei

intaktem Wechselstromnetz ohne zusätzliche Impedanzen mit dem Netz verbunden. Dadurch ergibt sich eine aufwendige Einrichtung. Überdies ist der Klirrfaktor des Netzstromes bei Batterieladung hoch, und es werden beim Ausfallen des Umformers die Verbraucher nicht mehr mit. Spannung versorgt.

Ferner ist durch die DE-AS 20 14 680 eine Einrichtung der eingangs angegebenen Art bekannt, die gleichfalls eine Schaltungsanordnung zur unterbrechungsfreien Wechselstromversorgung eines Verbrauchers darstellt, mit einem reversiblen statischen Umformer für die Wechselstromversorgung des Verbrauchers, ohne Siebglied oder Drossel am Wechselstromausgang, oder für die Ladung einer Batterie, die als Energiequelle bei der Wechselstromversorgung des Verbrauchers dient. Zwischen dem Wechselstromausgang des Umformers und dem Verbraucher einerseits und einem Wechselstromnetz andererseits ist ein elektronisch gesteuerter statischer Schalter angeordnet. Unmittelbar am Wechselstromausgang des Umformers ist ein Stromwandler zur Erfassung des Umformer-Wechselstromes angeschlossen. Es ist dem Umformer eine sogenannte Blindstrom- und eine Wirkstromschaltung zugeordnet; der Ausgang der ersteren wirkt auf einen Spannungsregler, der Ausgang des letzteren sowie auch die Spannung der Batterie wirken über einen Spannungsvergleicher auf einen Frequenzregler ein.

Durch diese zwei Regelsysteme, die miteinander vermascht sind, wird bewirkt, daß bei vorhandener Netzspannung der elektronische Schalter geschlossen ist und, wenn die Batteriespannung ausreichend groß ist und der Umformer als Wechselrichter gesteuert wird, die Wechselrichterspannung an die Netzspannung angepaßt ist und mit dieser synchronisiert wird. Ist dagegen die Batteriespannung abgefallen, so wird die Batterie über den als Gleichrichter gesteuerten Umformer geladen. Fällt die Netzspannung ab, dann wird der elektronische Schalter geöffnet und es wird der Umformer zur Ersatzstromversorgung als Wechselrichter gesteuert.

Auch diese Einrichtung ist für die Ausführung ihrer vorgesehenen Funktionen verhältnismäßig aufwendig, zumal mehrere Regelgrößen beim Ablauf der Funktionen sich gegenseitig beeinflussen, da die erwähnten Regelsysteme nicht voneinander entkoppelt sind.

Die der Erfindung zugrunde liegende Aufgabe besteht in einer Verbesserung und Ausbildung zur Mehrzweckanwendung der eingangs definierten Einrichtung in der Weise, daß damit unter Aufwendung von im Vergleich mit dem zuvor betrachteten Stand der Technik wenig Schaltungs- und Elektronikmitteln eine energiesparende kontinuierliche Wechselstromversorgung ermöglicht wird, in der insbesondere Entladeperioden zur Kapazitätsprobe der Batterie einbegriffen sein sollen.

Durch die im Patentanspruch 1 gekennzeichneten Merkmale wird diese Aufgabe gelöst. Demgemäß sind eine Impedanz und ein dritter Schalter zwischen dem statischen Umformer und dem Wechselstromnetz angeordnet, und es ist dem statischen Umformer eine zusätzliche Steuerungseinrichtung zugeordnet, mit der jeweils durch Einstellung einer Phasenabweichung der Wechselspannung des Umformers von der Spannung des Wechselstromnetzes eine Synchronisation dieser Wechselspannungen für den Parallelbetrieb des Wechselrichters und des Wechselstromnetzes bewirkt wird und bei Normalstromversorgung der Verbraucher für die Ladung der Batterie ein aus dem Wechselstromnetz über den als Gleichrichter wirkenden Umformer fließender Strom oder ein aus der Batterie über den als Wechselrichter wirkenden Umformer in das Wechselstromnetz fließender Strom für eine Entladung der Batterie einstell- oder regelbar ist.

Nach einer Ausgestaltung der Erfindung gemäß Patentanspruch 2 werden der erste und der zweite Schalter durch eine Verbindung zwischen Wechselstromnetz und statischem Umformer über eine Drossel als Impedanz mittels eines dritten Schalters überbrückbar; oder es ist eine Drossel als Impedanz zwischen dem ersten Schalter und den Verbrauchern angeordnet und dieser Drossel ist ein Überbrükkungsschalter zugeordnet (Patentanspruch 3); oder es ist nur der zweite Schalter durch eine Verbindung zwischen dem Wechselstromnetz und dem statischen Umformer über eine Drossel als Impedanz mittels eines dritten Schalters überbrückbar.

Weiterhin erfindungsgemäß ist die erwähnte Drossel so dimensioniert, daß bei gegebener Netzspannung und eingestellter Phasenabweichung der Wechselrichterspannung von der Netzspannung ein gewünschter Strom bei vorgegebenem Leistungsfaktor ($\cos \varphi$) fließt.

Mit der erfindungsgemäß ausgebildeten Einrichtung wird durch die erwähnte Drossel bei jeder Betriebsart der kontinuierlichen Wechselstromversorgung, auch bei den Betriebsarten Laden und Entladen der Batterie, im Gegensatz zu den oben betrachteten, bekannten Einrichtungen eine sichere Entkopplung des Umformers und des Wechselstromnetzes erreicht. Der Ladestrom (für die Batterie) ist regelbar mit der Phasenabweichung zwischen der Ausgangsspannung des (für die Batterie) als Gleichrichter wirkenden Umformers und der Netzspannung. Ferner ist mit der Phasenabweichung zwischen der Ausgangsspannung des als Wechselrichter wirkenden Umformers und der Netzspannung der Entladestrom der Batterie, bei der Kapazitätsprobe, regelbar oder einstellbar.

Bei vorhandener Netzspannung ist die Normalstromversorgung der Verbraucher auch möglich, wenn (nur) der dem Ausgang des Umformers zugeordnete Schalter geschlossen ist. Dann wird bei geeigneter Dimensionierung der Drossel die Verbraucherspannung praktisch nicht von Schwankungen der Netzspannung beeinflußt. Fällt der Umformer aus, dann können die Verbraucher direkt auf das Wechselstromnetz umgeschaltet werden.

Eine Einrichtung gemäß der Erfindung kann schließlich zur Anpassung an ein verfügbares entsprechendes Wechselstromnetz mit einem einphasigen oder einem drei- oder mehrphasigen statischen Umformer für Batterieladen oder für die Kapazitätsprobe ausgestattet sein.

Die Erfindung wird nachstehend anhand der Zeichnung durch Ausführungsbeispiele beschrieben; in der

    Figur 1 ein Blockschaltbild der Einrichtung gemäß der Erfindung,

    Figur 2 ein Blockschaltbild der Einrichtung mit einer anderen Anordnung gemäß der Erfindung,

    Figur 3 zur Erläuterung der Regelvorgänge bei einer erfindungsgemäßen Einrichtung nach Fig.1 oder 2 ein Zeigerdiagramm der Betriebsart Batterieladen darstellt,

    Figur 4 zur Erläuterung der Regelvorgänge ein Zeigerdiagramm der Betriebsart Kapazitätsprüfung darstellt.

Zur Beschreibung eines ersten Ausführungsbeispiels wird auf die Fig.1 Bezug genommen. Die als Blockschaltbild dargestellte Einrichtung ist an zwei Energiequellen, ein Wechselstromnetz M einerseits und eine Akkumulatorbatterie B andererseits angeschlossen. Die Einrichtung enthält einen statischen einphasigen Umformer, einen Thyristor-Stromrichter, der im folgenden kurz Umformer WR bezeichnet wird. Dem Umformer ist außer einer Steuereinheit, mit der für die Thyristoren des Stromrichters die Steuerimpulse erzeugt und den Thyristoren zugeführt werden, eine zusätzliche Steuereinrichtung zugeordnet; mittels der zusätzlichen Steuerungseinrichtung kann die Phasenlage der zur Netzspannung $u_M$ synchronen Umformerspannung $u_{WR}$ verändert werden. Der (reversible) Umformer hat als Vierpol betrachtet zwei Polpaare, ein Gleichstrom- und ein Wechselstrompolpaar, die jeweils nach Wirkungsart Eingang oder Ausgang sein können. Nachstehend werden beide jedoch Ausgänge bezeichnet. Mit dem Gleichstromausgang ist der Umformer an der Batterie B angeschlossen und mit dem Wechselstromausgang am Wechselstromnetz M. Von den zwei Phasenleitern, durch die der Umformer an das Wechselstromnetz angeschlossen ist, zweigt ein Verbraucherabgang zu Verbrauchern V ab. In einem der zwei Phasenleiter liegen ein erster (S1) und ein zweiter Schalter (S2). S1 ist einerseits mit dem Wechselstromnetz und andererseits mit den Verbrauchern und dem Umformer verbunden; S2 ist einerseits mit den Verbrauchern und dem Wechselstromnetz und andererseits mit dem Umformer verbunden. Es ist entweder S1 oder S2 geschlossen. Eine Impedanz, nach Fig.1 und 2 eine Drossel D, die nach Fig.1 in einem die Reihe der Schalter S1 und S2 überbrückenden Stromzweig mit einem dritten Schalter S3 zwischen M und dem System (B, WR) angeordnet ist, dient als Entkopplungselement. Hingegen ist bei einem zweiten Ausführungsbeispiel (nach Fig.2) die Drossel D in einem Phasenleiter zwischen S1 und dem Verbraucherabgang angeordnet. Hier ist der Drossel ein Überbrückungsschalter S4 zugeordnet. Bei einem dritten Ausführungsbeispiel (nicht dargestellt) liegt die Drossel D mit einem dritten Schalter S3 in einer nur den ersten Schalter S1 überbrückenden Verbindung zwischen WR und M.

Die beschriebene Einrichtung ist für eine kontinuierliche Wechselstromversorgung von Verbrauchern vorgesehen, bei der grundsätzlich zwei Systeme, ein statischer Wechselrichter mit einer Batterie und ein Wechselstromnetz zusammenwirken, und zwar meistens im Parallelbetrieb des Wechselrichters und des Wechselstromnetzes über die Drossel D, ferner zur Stromversorgung von Verbrauchern allein aus dem System Batterie-Wechselrichter, nämlich Ersatzstromversorgung, wenn das zur Normalstromversorgung der Verbraucher angewendete Wechselstromnetz ausgefallen ist, und schließlich zur Normalstromversorgung aus dem Netz M, wobei S1 geschlossen ist und der Wechselrichter synchron mit dem Netz mitläuft, die Batterie über S3 geladen wird und für einen Netzausfall in Bereitschaft gehalten ist. Eine kontinuierliche Wechselstromversorgung erfordert, daß für die Ersatzstromversorgung die Batterie in Bereitschaft gehalten ist, wobei ständig genügend Energie in der Batterie gespeichert sein muß. Dazu wird anstelle eines Wechselrichters ein reversibler Umformer, wie oben bezeichnet, verwendet, der während der Normalstromversorgung als Gleichrichter steuerbar ist zum Laden der Batterie. Eine kontinuierliche Stromversorgung erfordert bei bestimmten Anwendungen eine Einrichtung, mit der das Speichervermögen der Batterie durch Kapazitätsproben geprüft werden kann. Eine Kapazitätsprobe erfolgt durch eine Entladung der Batterie und Entnahme einer Ladungsmenge, d.h. eines bestimmten Entladestromes in einem bestimmten Zeitabschnitt. Mit Hilfe der oben beschriebenen Einrichtung ist eine Kapazitätsprobe während der Normalstromversorgung energiesparend durchführbar, indem die Batterie über den als Wechselrichter wirkenden Umformer in das Netz entladen wird. Weitere mögliche Betriebsarten sind: Laden der Batterie oder Kapazitätsprobe bei vorhandener Netzspannung, wobei S3 geschlossen ist, und die Verbraucher über den geschlossenen Schalter S2 vom Wechselrichter versorgt werden.

Der oben erwähnten Drossel D sind bei allen vorstehend angegebenen Betriebsweisen eine Entkopplungs- und eine Steuerfunktion zugedacht. Ohne Impedanz oder Drossel besteht beim Parallelbetrieb eine starre Kopplung der Systeme (M, WR und B). Es ergeben sich hierbei Schwierigkeiten bei der Spannungsregelung und Gleichlaufregelung des Wechselrichters, die nur mit großem Aufwand von Steuerungsmitteln beherrschbar sind. Um Ausgleichsströme zwischen den zwei Systemen zu unterdrücken, müssen die Amplituden der Wechselspannungen und die Phasenwinkel untereinander gleichgeregelt sein. Durch eine Impedanz zwischen den Systemen, z.B. eine Induktivität, wird eine nachgiebige Kopplung bewirkt. Dabei wird durch die Steuerung des Wechselrichters und einen Regelkreis mit Regler für den Phasenwinkel oder die Freqenz des Wechselrichters Synchronlauf mit einer bestimmten Phasenabweichung $\Delta\psi$ zwischen den Wechselspannungen $u_M$ und $u_{WR}$ hergestellt, so daß der Wechselrichter mit Netzfreqenz läuft. An der Drossel D besteht eine Wechselspannung $u_D$ mit einer Phasenlage, die sich als Differenzspannung $u_D = u_M - u_{WR}$ darstellt. Der in der Drossel fließende Strom $i_D$ ist z.B. bei den Betriebsarten Batterieladen oder Kapazitätsprobe um $90^o$ el gegenüber der Spannung $u_D$ nacheilend. Dadurch, daß eine Entkopplung von Wechselrichter WR und Netz M durch die Drossel bewirkt wird, sind auch Regelkreise, die WR und M gesondert zugeordnet sein können, voneinander sicher getrennt. Die Energieflußrichtung zwischen den erwähnten Systemen beim Laden der Batterie aus dem Netz über den als Gleichrichter wirkenden Umformer WR oder über den als Wechselrichter wirkenden Umformer bei der Kapazitätsprobe ist durch die Phasenabweichung $\Delta\psi$ der Spannung $u_{WR}$ von der Netzspannung $u_M$ bestimmt. Im ersten Falle (s.Fig.3) ist $u_M$ gegenüber $u_{WR}$ voreilend, es fließt ein Wirkstrom aus dem Netz. Im zweiten Fall (s.Fig.4) ist $u_M$ gegenüber $u_{WR}$ nacheilend, ein Wirkstrom fließt ins Netz. Hierbei wird der Wechselrichter mit einem um den Phasenwinkel $\psi$ nacheilenden (induktiven) Strom belastet, der die Batterie entlädt.

Durch die Drossel D werden Auswirkungen von Störeinflüssen, die vom Wechselstromnetz M ausgehen, auf den Wechselstromausgang des Umformers bzw. Wechselrichters minimiert.

Bei gegenüber $u_{WR}$ voreilender Netzspannung $u_M$ ist der Strom $i_M$ aus dem Netz um $1/2 \Delta\psi$ nacheilend. Wenn $u_M$ und $u_{WR}$ gleiche Amplituden haben, gilt im Knotenpunkt Verbraucherabgang nach Fig.1 bei geschlossenen Schaltern S2 und S3 die Beziehung $i_{WR} + i_M = i_V$ ($i_M = i_D$). Bei geschlossenen Schaltern S1 und S2 ergibt sich die gleiche Beziehung, wobei $i_{WR} = -i_D$ ist. Daraus ergibt sich bei Verbraucherstrom Null ($i_V = 0$) eine Energieflußrichtung, die von M über WR in die Batterie B gerichtet ist.

Zur Darstellung der Zusammenhänge der Spannungen und Ströme, die bei den oben betrachteten Betriebsarten bestehen, sind die Zeigerdiagramme der Fig.3 und 4 in der komplexen Zahlenebene (Im = imaginär, Re = reell) dargestellt. Darin ist zugrundegelegt, daß die Netz- und die Wechselrichterspannung gleiche Beträge haben und daß keine Belastung erfolgt.

Es läßt sich zeigen, daß dann die Beziehung

$$u_D = 2\, u_{WR} \sin \frac{\Delta\psi}{2}$$

besteht. Es kann anhand dieser Beziehung eine Induktivität L der Drossel D angegeben werden, mit der die Drossel für die meisten Anwendungen als Entkopplungs- und als Steuerelement für die kontinuierliche Stromversorgung hinreichend ausgelegt und dimensioniert ist. Die Drossel hat eine Induktivität L =

$$\frac{1}{\omega i_D} \cdot u_D = \frac{2}{\omega I_D} \cdot u_M \sin \frac{\Delta\psi}{2}$$

worin $u_M$ = 220 Volt, $\omega$ = 314/s und $u_D$ , $\Delta\psi$ jeweils feste Grenzwerte bedeuten. Zur Bestimmung von L sind Werte für den Drosselstrom $i_D$ und für die Phasenabweichung $\Delta\psi$ festzulegen. Dabei zeigt sich, daß die Drossel bei Wahl einer Phasenabweichungvon maximal ungefähr 60° el optimal ausgelegt ist. Damit wird auch bei Netzausfall oder bei Kurzschluß eine unerwünscht große Belastung des Wechselrichters WR vermieden, und ferner wird der Netzstrom $i_{WR}$ begrenzt. Bei der vorangehend erläuterten Auslegung wirken sich Änderungen der Netzspannung $u_M$ auf den Wechselrichterstrom $i_{WR}$ nur schwach aus.

Die oben erwähnte zusätzliche Steuereinrichtung enthält mit Spannungsrelais, Stromrelais und/oder Zeitmeßrelais weitere und besondere Steuerfunktionen für die Betriebsarten Entladen der Batterie zur Kapazitätsprobe sowie auch Laden der Batterie. Es bestehen diese Steuerfunktionen darin, daß, sobald eine vorgegebene sogenannte minimale Entladespannung erreicht wird oder nach Ablauf einer vorgegebenen Entladezeit, wie z.B. nach 3 Stunden, und/oder bei einem Ausfall des Wechselstromnetzes oder einer anderen die Kapazitätsprobe beeinflussenden Störung, das Entladen der Batterie zur Kapazitätsprobe beendet bzw. unterbrochen wird und daraufhin die Stromversorgungseinrichtung, wenn immer das Wechselstromnetz intakt ist, auf die Betriebsart Batterieladen selbsttätig umgesteuert wird. Als weitere Steuerfunktionen enthält die Steuereinrichtung, daß nach Ablauf einer vorgegebenen Entladezeit für den Nachweis einer hinreichenden Batteriekapazität ein Kennsignal dafür erzeugt wird, die Kapazitätsprobe aber in Abhängigkeit von der überwachten Entladespannung der Batterie beendet wird, daß daraufhin die Entladezeit angezeigt und die Einrichtung selbsttätig auf Batterieladen umgesteuert wird.

Des weiteren werden, nachdem infolge eines Netzausfalls
die Kapazitätsprobe unterbrochen worden ist, die Verbraucher auf das System B, WR zur Ersatzstromversorgung
schnellumgeschaltet. Bei Wiederkehr der Netzspannung
schließlich werden die Verbraucher auf das Wechselstromnetz zurückgeschaltet, alsdann wird die Kapazitätsprobe
fortgesetzt, oder es wird auf die Betriebsart Batterieladen umgesteuert.

Patentansprüche:

1. Einrichtung für die kontinuierliche Wechselstromversorgung von Verbrauchern aus einem Wechselstromnetz oder über einen als Wechselrichter wirkenden statischen Umformer, bei welcher Einrichtung ein erster Schalter zwischen Wechselstromnetz und den Verbrauchern (einerseits) sowie ein zweiter Schalter zwischen den Verbrauchern und dem Wechselrichter (andererseits) angeordnet sind, dadurch gekennzeichnet, daß zwischen dem statischen Umformer und dem Wechselstromnetz eine Impedanz und ein dritter Schalter angeordnet sind und daß dem statischen Umformer eine zusätzliche Steuerungseinrichtung zugeordnet ist, mit der jeweils durch Einstellung einer Phasenabweichung der Wechselspannung des Umformers von der Spannung des Wechselstromnetzes eine Synchronisation dieser Wechselspannungen für den Parallelbetrieb des Wechselrichters und des Wechselstromnetzes bewirkt wird und bei Normalstromversorgung der Verbraucher für die Ladung der Batterie ein aus dem Wechselstromnetz über den als Gleichrichter wirkenden Umformer fließender Strom oder ein aus der Batterie über den als Wechselrichter wirkenden Umformer in das Wechselstromnetz fließender Strom für eine Entladung der Batterie einstell- oder regelbar ist.

2. Einrichtung nach Anspruch 1, dadurch gekennzeichnet, daß der erste und der zweite Schalter durch eine Verbindung zwischen dem Wechselstromnetz und dem statischen Umformer über eine Drossel als Impedanz mittels eines dritten Schalters überbrückbar sind.

3. Einrichtung nach Anspruch 1, dadurch gekennzeichnet, daß zwischen dem ersten Schalter und den Verbrauchern eine Drossel als Impedanz angeordnet und daß der Drossel ein Überbrückungsschalter zugeordnet ist.

4. Einrichtung nach Anspruch 1, dadurch gekennzeichnet, daß nur der zweite Schalter durch eine Verbindung zwischen dem Wechselstromnetz und dem statischen Umformer über eine Drossel als Impedanz mittels eines dritten Schalters überbrückbar ist.

5. Steuereinrichtung nach Anspruch 1 bis 3, dadurch gekennzeichnet, daß die Steuereinrichtung Spannungsrelais, Stromrelais und/oder Zeitmeßrelais enthält, durch die während der Entladung der Batterie zur Kapazitätsprobe beim Erreichen einer minimalen Entladespannung oder nach Ablauf einer vorgegebenen Entladezeit und/oder bei einem Netzausfall bzw. einer anderen die Kapazitätsprobe beeinflussenden Störung die Kapazitätsprobe beendet wird und bei intaktem Wechselstromnetz die Umschaltung auf Batterieladung über den als Gleichrichter wirkenden statischen Umformer selbsttätig steuerbar ist.

6. Steuereinrichtung nach Anspruch 5, dadurch gekennzeichnet, daß durch sie nach Ablauf einer vorgegebenen Zeit für den Nachweis ausreichender Batteriekapazität ein Meldesignal erzeugt wird und die Kapazitätsprobe selbsttätig weiterläuft, bis diese durch eine Überwachung der Entladespannung beendet wird, woraufhin die Gesamtladezeit angezeigt wird, und daß nach Beendigung der Kapazitätsprobe selbsttätig auf Batterieladung umgeschaltet wird.

7. Steuereinrichtung nach Anspruch 5, dadurch gekennzeichnet, daß durch sie bei einem Netzausfall die Kapazitätsprobe unterbrochen wird und die Verbraucher innerhalb kürzester Zeit auf den als Wechselrichter wirkenden statischen Umformer umgeschaltet werden und daß bei Wiederkehr der Spannung des Wechselstromnetzes die Verbraucher auf das Wechselstromnetz zurückgeschaltet werden und alsdann entweder die Kapazitätsprobe fortgesetzt oder auf Batterieladung selbsttätig umgeschaltet wird.

8. Steuereinrichtung nach Anspruch 1 bis 5, dadurch gekennzeichnet, daß durch sie bei der Entladung der Batterie zur Kapazitätsprobe eine feste Phasenabweichung für einen jeweils gewünschten Wirkstrom eingestellt wird, und daß dabei durch Störgrößenaufschaltung Änderungen der Netzspannung ausgeglichen werden.

9. Einrichtung nach Anspruch 1 bis 4, dadurch gekennzeichnet, daß die Impedanz mit einer Induktivität L so dimensioniert ist, daß bei gegebener Netzspannung und eingestellter Phasenabweichung der Wechselspannung des statischen Umformers von der Netzspannung ein gewünschter Strom bei vorgegebenem Leistungsfaktor (cos$\varphi$) fließt.

# FIG.1

# FIG.2

# FIG.3

# FIG.4

Europäisches
Patentamt

# EUROPÄISCHER RECHERCHENBERICHT

Nummer der Anmeldung
EP 80 10 1933

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | DE - A - 2 250 437 (A.G. BROWN, BOVERI & CIE.) <br><br> * Seite 4, Zeile 16 bis Seite 15, Zeile 12; Figuren 1,2,3 * <br><br> -- | 1,3,9 |
| | DE - A - 1 803 221 (INTERNATIONAL STANDARD ELECTRIC CORP.) <br><br> * Seite 3, Zeile 19 bis Seite 6, Zeile 13, Figur 1 * <br><br> -- | 1 |
| | DE - A - 2 617 625 (THEO BENNING ELEKTROGERÄTE KG) <br><br> * Seite 4, Zeile 24 bis Seite 5, Zeile 30; Figur * <br><br> -- | 1,5 |
| A | FR - A - 2 212 682 (S.A. DES ETS. ADRIEN DE BACKER) <br><br> * Seite 2, Zeile 20 bis Seite 4, Zeile 15; Figur 1 * <br><br> -- | 1 |
| A | BE - A - 691 194 (ALLMÄNNA SVENSKA ELEKTRISKA A.B.) <br><br> * Seite 3, Zeile 16 bis Seite 6, Zeile 22; Figur 2 * <br><br> -- <br><br> ./. | 1 |

### KLASSIFIKATION DER ANMELDUNG (Int.Cl. 3)

H 02 J 9/06
3/32
G 01 R 31/36

### RECHERCHIERTE SACHGEBIETE (Int. Cl. 3)

H 02 J 9/06
3/32
7/34
H 02 M 7/00
G 01 R 31/36

### KATEGORIE DER GENANNTEN DOKUMENTE

X: von besonderer Bedeutung
A: technologischer Hintergrund
O: nichtschriftliche Offenbarung
P: Zwischenliteratur
T: der Erfindung zugrunde liegende Theorien oder Grundsätze
E: kollidierende Anmeldung
D: in der Anmeldung angeführtes Dokument
L: aus andern Gründen angeführtes Dokument
&: Mitglied der gleichen Patentfamilie, übereinstimmendes Dokument

Der vorliegende Recherchenbericht wurde für alle Patentansprüche erstellt.

DEN HAAG

| Recherchenort | Abschlußdatum der Recherche | Prüfer |
|---|---|---|

Europäisches
Patentamt

**EUROPÄISCHER RECHERCHENBERICHT**

0018521

Nummer der Anmeldung

EP 80 10 1933

-2-

| | EINSCHLÄGIGE DOKUMENTE | | KLASSIFIKATION DER ANMELDUNG (Int.Cl. 3) |
|---|---|---|---|
| Kategorie | Kennzeichnung des Dokuments mit Angabe, soweit erforderlich, der maßgeblichen Teile | betrifft Anspruch | |
| A | US - A - 3 351 770 (B.J. O'SULLLI-VAN et al.)<br><br>\* Spalte 2, Zeile 17 bis Spalte 4, Zeile 68; Figuren 1,2 \*<br><br>------- | 1 | |
| | | | RECHERCHIERTE SACHGEBIETE (Int. Cl. 3) |